# EUROPEAN PATENT APPLICATION

(11) **EP 4 485 511 A1**
(43) Date of publication of application: **01.01.2025**
(21) Application number: 23182012.7
(22) Date of filing: 28.06.2023
(51) Int. Cl.: H01L 21/67

(54) **A SEALING SYSTEM AND A SYSTEM FOR SEALING AN OPENING IN A VACUUM SYSTEM**

(71) Applicant: ASML Netherlands B.V., 5500 AH Veldhoven (NL)
(72) Inventor: OVERLACK, Arthur, Eduard, 5500 AH Veldhoven (NL); KROON, Ronald, 5500 AH Veldhoven (NL)
(74) Representative: ASML Netherlands B.V.

(57) **Abstract**

The present invention provides a sealing system. The system comprises at least a part of a vacuum chamber, in which an opening is defined, and a printed circuit board. The printed circuit board comprises a first part for exposing to an atmospheric
environment, and a second part adjacent to the first part for exposing to a vacuum environment. The second part is configured to at least partially cover the opening in the vacuum chamber. The first part is configured to extend away from the opening for accommodating an interface.

## Description

### FIELD

The embodiments provided herein generally relate to sealing system and a system for sealing an opening in a vacuum system.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

During assessment, the gas in a region around a sample is typically removed. This creates a vacuum that is a local gas pressure lower than the pressure in the surrounding environment. There is a desire to feed through electrical signals in- and out of the vacuum environment. For example, control signals may be fed in to the vacuum environment to control components of the assessment system disposed within a vacuum chamber. Furthermore, measurement data of the sample, such as detection signals, may be fed out of the vacuum chamber for processing outside the vacuum and optionally off-site.

Such an electrical signal connection into the vacuum chamber has been provided by a connector to route the signals into or out of the vacuum chamber by clamping the connector between gaskets or gluing the connector to brackets of the vacuum chamber. For high speed data applications, connector choice is limited, and for connections with many channels/lines, high density connectors need to be used. This can lead to handling and reliability issues, as well as limited electrical signal performance. There is therefore a desire to provide a robust connector for reliable feed through of electrical signals between the vacuum environment and the atmospheric environments, whilst maintaining an effective seal in the vacuum chamber.

### SUMMARY

It is an object of the present disclosure to provide embodiments of a sealing system and a system for sealing an opening in a vacuum system.

According to a first aspect of the invention, there is provided a sealing system. The system comprises a vacuum chamber, in which an opening is defined, and a printed circuit board. The printed circuit board comprises a first part
for exposing to an atmospheric environment, and a second part adjacent to the first part for exposing to a vacuum environment. The second part is configured to at least partially cover the opening in the vacuum chamber. The first part is configured to extend away from the opening for accommodating an interface.

According to a second aspect of the invention, there is provided a system for sealing an opening in a vacuum system. The system comprises a printed circuit board, comprising a first part for exposing to an atmospheric environment, a second part adjacent to the first part for exposing to a vacuum environment and for covering the opening in the vacuum system, and a support structure configured to support the second part of the printed circuit board during exposure to the vacuum environment.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3A** is a schematic diagram illustrating a cross-sectional view of a system for sealing an opening in a vacuum system, including a printed circuit board configured to seal a circular opening, as viewed from the side.
**FIG. 3B** is a schematic diagram illustrating the system of **FIG. 3A** as viewed from below.
**FIG. 4A** is a schematic diagram illustrating a cross-sectional view of a system for sealing an opening in a vacuum system, including a printed circuit board configured to seal a rectangular opening, as viewed from the side.
**FIG. 4B** is a schematic diagram illustrating the system of **FIG. 4A** as viewed from below.
**FIG. 5A** is a schematic diagram illustrating a cross-sectional view of a system as shown in Fig. 3A-B further comprising a support structure configured to support the part of the printed circuit board during that is exposed to the vacuum environment, as viewed from the side.
**FIG. 5B** is a schematic diagram illustrating the system of **FIG. 5A** as viewed from below.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

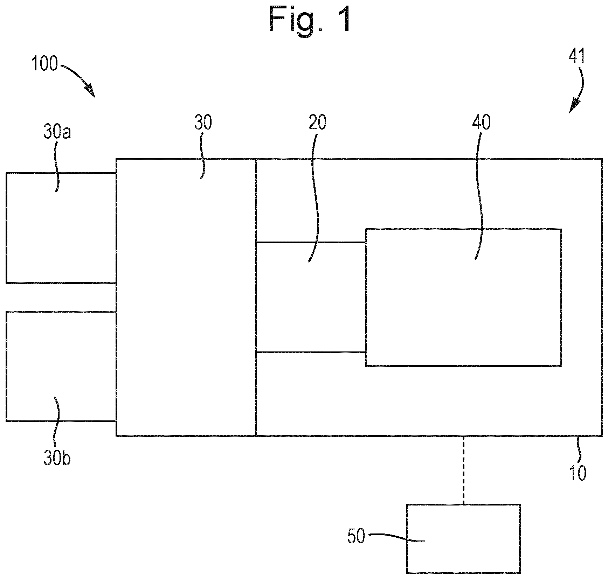

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

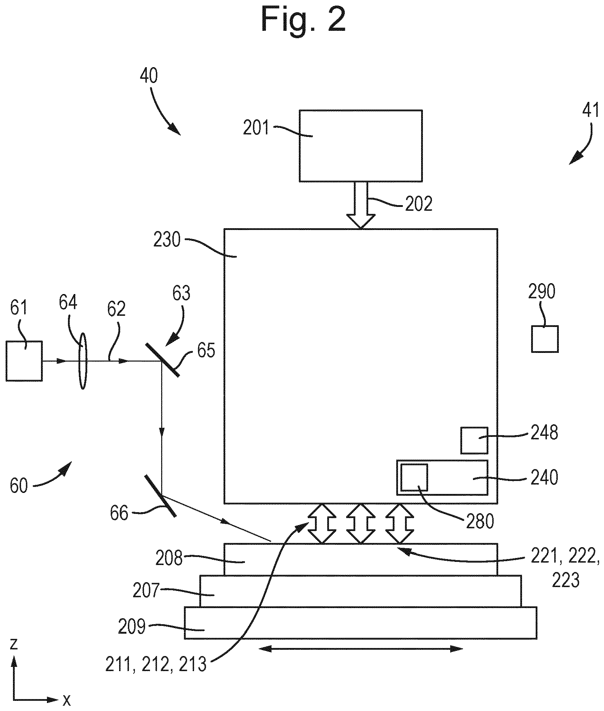

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2****).** However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

During assessment, the gas in a region around a sample is typically removed, for example using a load lock chamber 20, as shown in **FIG. 1****.** This creates a vacuum that is a local gas pressure lower than the pressure in the surrounding environment. There is a desire to feed through electrical signals in- and out of the vacuum environment. For example, control signals may be fed in to the vacuum environment to control components of the assessment system disposed within a vacuum chamber. Furthermore, measurement data of the sample, such as detection signals, may be fed out of the vacuum chamber for processing outside the vacuum and optionally off-site.

A system may be provided for sealing an opening in a vacuum system. For example, a charged particle assessment system 40, such as that of **FIG. 1** and **FIG. 2****,** may comprise a sealing system for sealing an opening in the vacuum system. In other words, a sealing system may be provided to both seal an opening in a vacuum system and to provide an interface, i.e., a connector, to enable electrical signals to be fed to and/or from the vacuum system.

The system for sealing an opening in a vacuum system, which may be referred to as a sealing system, may be used for applications other than sample assessment. The sealing system may be provided to any application involving passing signals, for example electrical and/or optical signals, to and/or from the inside, or vacuum environment, of a vacuum system. Additionally, or alternatively, the sealing system may be provided to any application involving passing fluids, for example cooling fluids, to and/or from the inside, or vacuum environment, of a vacuum system.

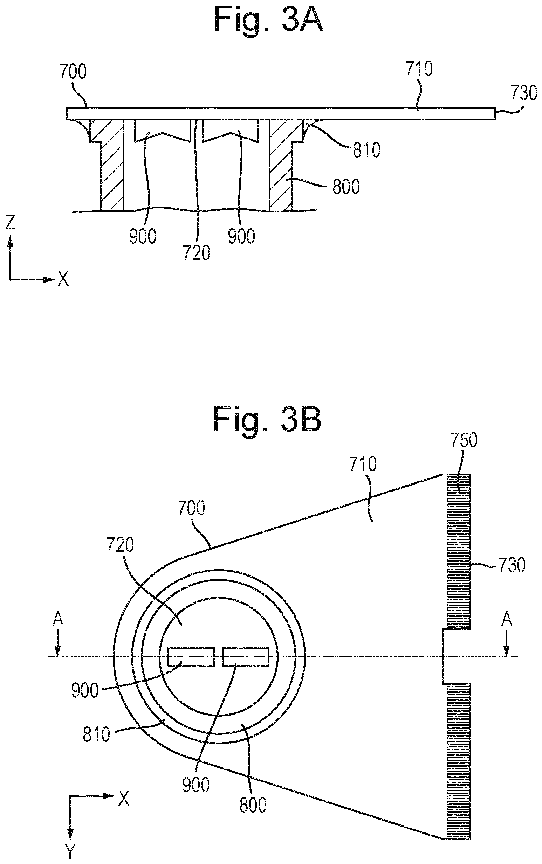

The sealing system, for sealing the vacuum system, may take the arrangement shown in FIG. 3A-B. **FIG. 3A** provides a cross-sectional view of the system, through axis A-A of **FIG. 3B****,** as viewed from the side. **FIG. 3B** provides a view of the system of **FIG. 3A** from below. The sealing system of FIG. 3A-B comprises a printed circuit board 700. The printed circuit board may be any suitable type of printed circuit board, desirably a ceramic printed circuit board.

The printed circuit board 700 comprises a first part 710 for exposing to an atmospheric environment, and the printed circuit board 700 comprises a second part 720 adjacent to the first part for exposing to a vacuum environment.

During use, the second part 720 of the printed circuit board 700 is exposed to a vacuum environment. In this way, the second part 720 of the printed circuit board 700 may seal an opening in a vacuum chamber such that the vacuum environment of the vacuum system can be maintained. The second part 720 is configured to at least partially cover the opening in the vacuum chamber. For example, one or more other components, such as a flange, bracket or gasket may act in combination with the second part to cover the opening. Alternatively, the second part 720 may be configured to entirely cover the opening in the vacuum chamber.

During use, the first part 710 of the printed circuit board 700 is exposed to the atmospheric environment. In other words, during use the first part 710 of the printed circuit board 700 may be disposed outside the vacuum system such that the first part 710 does not aid in maintaining the vacuum environment.

The first part 710 is configured to extend away from the opening for accommodating an interface. Electronics may directly mated to the interface in the atmospheric environment (outside the vacuum chamber), for example by using a matching Peripheral Component Interconnect Express (PCIe) standard. This arrangement may desirably provide a robust connectivity solution, allowing a large number of mating cycles. Furthermore, the printed circuit board provides a direct means of connection between the inside and outside of the vacuum chamber during use. With this arrangement, a risk of signal quality impairment is lower than alternative configurations, which may require intermediate connectors and/or wire harnesses to be used. This may advantageously provide a means to standardise high speed data connectivity.

In the sealing system of FIG. 3A-B, the second part 720 comprises a plurality of connectors 900. The sealing system desirably comprises one or more connectors 900 on the second part 720. The connectors 900 are configured to operate within the vacuum environment. In particular, the connectors 900 are desirably configured to enable signals, for example optical and/or electrical signals, to be provided to and/or from the vacuum system. For example, signals may be transferred between the inside and outside of the vacuum chamber via the connectors 900, in the vacuum environment (within the vacuum chamber), and the interface 750, in the atmospheric environment (outside the vacuum chamber). Additionally, or alternatively, one or more of the connectors 900 may be configured to enable fluid to be provided to and/or from the vacuum system.

As shown for example in FIG. 3A-B, the first part 710 may be configured to extend away from the opening in a lateral direction with respect to the opening. The printed circuit board 700 may be a substantially flat plate, with the second part 720 of the flat plate comprising a covering region configured to cover the opening, and the first part 710 of the flat plate comprising one or more surfaces extending away from the opening in the same plane as the covering region. The first part 710 may be configured to extend away from the opening in a direction perpendicular to a central axis through the opening. In other words, the first part 710 may be configured to extend away from the opening in a direction perpendicular to a central axis through an aperture, or hole, in a wall of the vacuum chamber which defines the opening. The first part 710 may comprise a surface of the printed circuit board opposite a side of the printed circuit board comprising the covering region.

In the example as shown in FIG. 3A-B, the opening extends in an X-Y plane with a central axis through the opening extending in a Z-axis direction. The first part 710 extends away from the opening in at least an X-axis direction, such that the interface 750 is a distance from the opening in the X-axis direction. In other words, the interface 750 is off-set from the opening in a direction in which the first part 710 extends away from the opening.

In the example of FIG. 3A-B, the first part 710 extends away from the opening in a single direction, the X-direction, and may accommodate only a single interface 750. In an alternative arrangement, the first part may extend away from the opening in multiple directions, for example, directions in the same plane, such as the Y-direction, and/or directions in a different plane, such as the Z-direction. Furthermore, the first part may be configured to accommodate a plurality of interfaces. For example, the first part may extend away from the openings in a single direction for accommodating a plurality of interfaces in that direction. Alternatively, the first part may extend away from the openings in a plurality of directions for accommodating one or more interfaces in each direction.

The interface may comprise electronic input and/or output channels, cooling fluid input and/or output channels, and/or optical input and/or output channels. In the arrangement shown in FIG. 3A-B, the first part 710 comprises an interface 750. The interface 750 of the printed circuit board 700 of FIG. 3A-B is a printed circuit board edge connector. In other words, the traces of the interface 750 of FIG. 3A-B extend to an edge 730 of the printed circuit board.

The first part 710 of the printed circuit board 700 may comprise passive and/or active components. The extended distance between the opening and the interface may provide space for these components on the printed circuit board 700.

The vacuum chamber may comprise a wall defining the opening, or hole. In an implementation, the printed circuit board 700 may be attached to a wall surrounding the opening such that the second part 720 at least partially, and desirably entirely, covers the opening. Optionally, the printed circuit board may be directly attached to the wall of the vacuum chamber by any suitable means, for example via a weld, solder or glue.

Alternatively, as shown in FIG. 3A-B, the vacuum chamber may comprise a flange 800 surrounding the hole in the wall of the vacuum chamber. The flange 800 may be configured to extend away from the wall of the vacuum chamber. The flange 800 may define an opening, for example at the distal end of the flange which is the end of the flange farthest from the wall of the vacuum chamber. The printed circuit board 700 may then be attached to the flange 800. The second part 720 of the printed circuit board 700 is configured to cover the opening in the end of the flange 800. The flange 800 may extend outwards from the wall of the vacuum chamber, for example providing a tubelike extension, between the opening and the printed circuit board 700. In this way, the flange 800 together with the second part 720 of the printed circuit board 700 may seal the hole such that a vacuum can be maintained in the vacuum chamber. The printed circuit board 700 may be attached to the flange by any suitable means, for example via a weld 810, such as shown in FIG. 3A-B, solder or glue.

In the sealing system of FIG. 3A-B, the second part 720 of the printed circuit board 700 is configured to seal a circular opening in the vacuum chamber. In particular, as shown in FIG. 3A-B, the flange 800 defines a circular opening which is covered entirely by the second part 720. Alternatively, the circular opening may be a hole in a wall of the vacuum chamber which the printed circuit board may cover directly, for example in the absence of a flange.

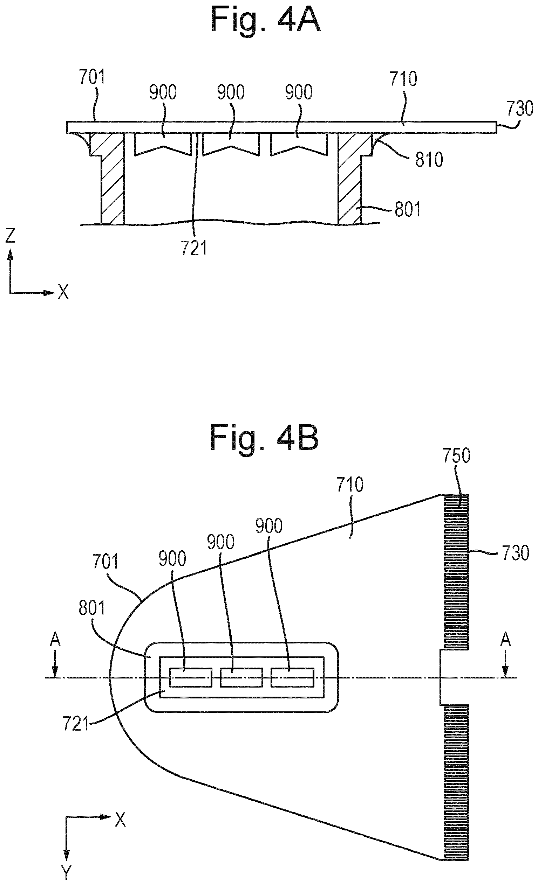

A sealing system, for sealing the vacuum system, may take the arrangement shown in FIG. 4A-B. **FIG. 4A** provides a cross-sectional view of the system, through axis A-A of **FIG. 4B****,** as viewed from the side. **FIG. 4B** provides a view of the system of **FIG. 4A** from below. The sealing system of FIG. 4A-B comprises a printed circuit board 701 the same as the printed circuit board 700 of FIG. 3A-B except that the printed circuit board 701 of FIG. 4A-B is configured to accommodate a non-circular opening in the vacuum chamber. In other words, the system may be configured to seal a non-circular opening in a flange or a wall of the vacuum chamber.

The system of FIG. 4A-B comprises a first part 710, an interface 750, and edge 730 of the printed circuit board 701, and a plurality of connectors 900 which may be the same as the corresponding above-described components of the system of FIG. 3A-B.

In the arrangement of FIG. 4A-B, a second part 721 adjacent to the first part for exposing to a vacuum environment. In the illustration of FIG. 4A-B, the vacuum chamber comprises a flange 801 having a non-circular opening. The second part 721 of printed circuit board 700 is suitable for covering the non-circular opening in the flange 801 of the vacuum system. In an alternative arrangement, the second part 721 of printed circuit board 700 may directly cover a non-circular hole in a wall of the vacuum chamber.

The non-circular opening desirably has a greater length in a longitudinal direction of the opening than the length of the opening in a width direction of the opening, wherein the width direction of the opening is orthogonal to the longitudinal direction of the opening. In other words, the opening may be narrower in one direction (e.g., the Y direction of **FIG. 4B****)** than in an orthogonal direction (e.g., the X direction of **FIG. 4B****).** With this arrangement, a plurality of connectors 900 may be arranged on the second part 721 in an array. For example, as shown in FIG. 4A-B, the connectors 900 are arranged in a line, or 1-dimensional array. In this way, the narrow opening may accommodate a plurality of connectors 900.

The opening being narrow reduces the likelihood of bending of the printed circuit board 701 due to pressure differential between the vacuum environment and the atmospheric environment is reduced. In particular, the likelihood of bowing or bending of the second part 721, or covering region, is reduced due to the narrow opening, compared to the risk of bending in a system having a circular or square opening in the vacuum system. Bending is undesirable because it may reduce the ability of the printed circuit board to function effectively either at sealing the vacuum chamber or at relaying signals via connectors and/or interfaces, or both.

The opening is desirably substantially elliptical, more desirably, substantially oval, and yet more desirably substantially rectangular. For example, as shown in **FIG. 4B****,** the flange 801 defines a substantially rectangular opening.

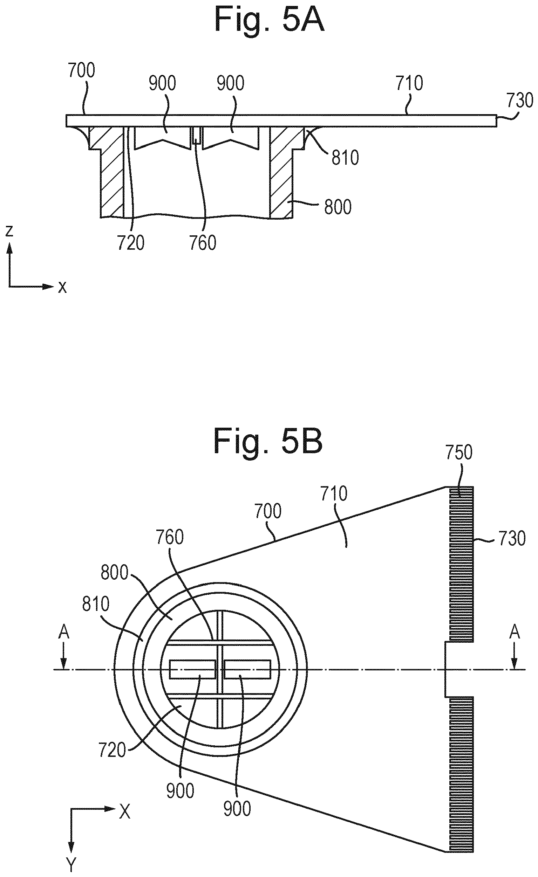

A sealing system, for sealing the vacuum system, may take the arrangement shown in FIG. 5A-B. **FIG. 5A** provides a cross-sectional view of the system, through axis A-A of **FIG. 5B****,** as viewed from the side. **FIG. 5B** provides a view of the system of **FIG. 5A** from below. The sealing system of FIG. 5A-B comprises a printed circuit board 700 the same as the printed circuit board 700 of FIG. 3A-B except that the system of FIG. 5A-B further comprises a support structure 760. The support structure 760 is configured to support the second part 720 of the printed circuit board during exposure to the vacuum environment. The support structure 760 desirably reinforces the second part 720 of the printed circuit board 700 on a surface for exposure to the vacuum environment during use. A similar support structure may be provided to support the second part 721 of the printed circuit board 701 of FIG. 4A-B.

The support structure 760 may be disposed on the printed circuit board 700, 701. For example, the support structure 760 may be formed on, or attached to, a surface of the second part of the printed circuit board. Alternatively, the support structure may be disposed across the opening of the vacuum chamber. For example, the support structure may be formed on, or attached to, a rim surrounding of the opening of the vacuum chamber. The support structure may be attached for example by welding or gluing. In an arrangement comprising a flange, the support structure may be attached to the flange, for example to extend across an opening at an end of the flange that is distal from the vacuum chamber.

The support structure may reduce a risk of the printed circuit board bending, particularly at the second part, due to the pressure differential between the vacuum environment and the atmospheric environment on either side of the second part of the printed circuit board.

The support structure is desirably arranged such that a continuous unsupported area of the second part 720 does not exceed an unsupported area threshold. The unsupported area threshold may be determined as an area below which an amount of bending of the printed circuit board at the second part, due to pressure differential between the atmosphere environment on one side and the vacuum environment on the other side of the printed circuit board, is within an acceptable range.

The support structure may comprise one or more beams. Each beam may be provided to reduce the continuous unsupported area of the second part. The beams are desirably arranged such that a continuous unsupported length of the second part 720 does not exceed an unsupported length threshold. In other words, the maximum distance between two beams preferably does not exceed an unsupported length threshold.

The beams may be formed on, or attached to, the printed circuit board. Alternatively, the beams may be formed on, or attached to, the flange or wall of the vacuum chamber adjacent to the opening. In one arrangement, the flange or wall of the vacuum chamber may define a series of slots adjacent to a rim surrounding the opening. The slots are desirably configured to receive the beams, such that during use the beams extend across the opening and are secured in place by the slots. In a different arrangement, the beams may be integrally formed as part of the flange or the wall of the vacuum chamber.

The support structure may be in the form of a mesh. In other words, the support structure may define a series of tessellated unsupported areas of the second part. Each unsupported area of the second part may, for example, have a substantially rectangular shape, or a substantially square shape, or a substantially hexagonal shape. Each unsupported area preferably does not exceed the unsupported area threshold. The maximum distance between the edges of each unsupported area preferably does not exceed the unsupported length threshold. The mesh may, for example, be formed of a plurality of beams. Alternatively, the mesh may be a single continuous component. The mesh may be formed on, or attached to, the printed circuit board. Alternatively, the mesh may be formed on, or attached to, the flange or wall of the vacuum chamber adjacent to the opening. In one arrangement, the flange or wall of the vacuum chamber may define a slot adjacent to a rim surrounding the opening. The slot is desirably configured to receive the mesh, such that during use the mesh extends across the opening and is secured in place by the slot. In a different arrangement, the mesh may be integrally formed as part of the flange or the wall of the vacuum chamber.

Alternatively, or additionally, the support structure includes a plate configured to cover at least part of the second part. For example, the plate may be provided on a covering region of the second part. The plate may cover all or part of a facing surface of the second part, wherein the facing surface is configured to be exposed to the vacuum environment during use. The facing surface may consist of connection regions on which connectors 900 are disposed and one or more non-connection regions, on which connectors are not disposed. The plate may be configured to entirely cover the one or more non-connection regions of the facing surface of the second part. In this way, the second part may be supported such that it does not bend excessively during use. The plate may be formed on, or attached to, the printed circuit board. Alternatively, the plate may be formed on, or attached to, the flange or wall of the vacuum chamber adjacent to the opening. In one arrangement, the flange or wall of the vacuum chamber may define at least one slot adjacent to a rim surrounding the opening. The at least one slot is desirably configured to receive the plate, such that during use the plate extends across the opening and is secured in place by the at least one slot. In a different arrangement, the plate may be integrally formed as part of the flange or the wall of the vacuum chamber.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components, such as the elements 300' of the respective component, to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one of the sub-devices 42 (a reference sub-device) may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Embodiments include the following numbered clauses:
1. A sealing system, the system comprising:
   a vacuum chamber in which an opening is defined; and
   a printed circuit board comprising:
      a first part for exposing to an atmospheric environment, and
      a second part adjacent to the first part for exposing to a vacuum environment,
      wherein the second part is configured to at least partially cover the opening in the vacuum chamber,
   wherein the first part is configured to extend away from the opening for accommodating an interface.
2. A sealing system for a vacuum chamber in which an opening is defined, the system comprising:
   a printed circuit board comprising:
      a first part for exposing to an atmospheric environment, and
      a second part adjacent to the first part for exposing to a vacuum environment,
      wherein the second part is configured to at least partially cover the opening in the vacuum chamber,
   wherein the first part is configured to extend away from the opening for accommodating an interface.
3. The system of clause 1 or 2, further comprising a support structure configured to support the second part of the printed circuit board during exposure to the vacuum environment.
4. The system of clause 3, wherein the support structure is disposed on the second part of the printed circuit board.
5. The system of clause 3, wherein the support structure is disposed across the opening of the vacuum chamber.
6. The system of clause 5, wherein the support structure is attached to a rim of the opening of the vacuum chamber.
7. The system of any of the preceding clauses, wherein the vacuum chamber comprises a wall defining the opening, and wherein the printed circuit board is attached to the wall such that the second part at least partially covers the opening.
8. The system of any of clauses 1 to 6, wherein the vacuum chamber comprises a flange surrounding the opening, and wherein the printed circuit board, in use, is attached to the flange.
9. The system of clause 8 when dependent on clause 3, wherein the support structure, in use, is attached to the flange.
10. The system of any of the preceding clauses, wherein the printed circuit board is soldered, welded, or glued to the vacuum chamber such that the second part at least partially covers the opening.
11. The system of any of the preceding clauses, wherein the opening is non-circular.
12. The system of any of the preceding clauses, wherein the opening has a greater length in a longitudinal direction of the opening than the length of the opening in a width direction orthogonal to the longitudinal direction.
13. The system of clauses 12, wherein the opening is substantially rectangular.
14. The system of any of the preceding clauses, wherein the second part is configured to entirely cover the opening.
15. A system for sealing an opening in a vacuum system, the system comprising:
   a printed circuit board comprising:
   a first part for exposing to an atmospheric environment,
   a second part adjacent to the first part for exposing to a vacuum environment and for covering the opening in the vacuum system, and
   a support structure configured to support the second part of the printed circuit board during exposure to the vacuum environment.
16. The system of clause 15, wherein the support structure is disposed on the second part of the printed circuit board.
17. The system of clause 15, wherein the support structure is disposed across the opening of the vacuum chamber.
18. The system of any of clauses 15 to 17, wherein the first part extends away from the second part, and wherein the first part accommodates an interface.
19. The system of any of the preceding clauses, wherein the interface comprises electronic input and/or output channels, cooling fluid input and/or output channels, and/or optical input and/or output channels.
20. The system of any of the preceding clauses, wherein the interface comprises a printed circuit board edge connector.
21. The system of any of clauses 3 to 20, wherein the support structure is in the form of a mesh.
22. The system of any of clauses 3 to 20, wherein the support structure includes one or more beams.
23. The system of any of clauses 3 to 20, wherein the support structure includes a plate configured to cover at least part of a surface of the second part.
24. The system of clause 23, wherein the surface of second part is a surface which is configured to be exposed to the vacuum environment during use.
25. The system of any of clauses 3 to 24, wherein the support structure is arranged such that a continuous unsupported area of the second part does not exceed an unsupported area threshold.
26. The system of any of the preceding clauses, wherein the first part comprises passive and/or active components.
27. The system of any of the preceding clauses, wherein the printed circuit board is a ceramic printed circuit board.
28. The system of any of the preceding clauses, wherein the first part is configured to extend away from the opening in a lateral direction with respect to the opening.
29. The system of any of the preceding clauses, wherein the first part is configured to extend away from the opening in a direction perpendicular to a central axis through the opening.
30. A charged particle assessment system, comprising a system according to any of the preceding clauses.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

Although specific reference may have been made above to the use of embodiments of the invention in the context of optical lithography, it will be appreciated that the invention, where the context allows, is not limited to optical lithography.

## Claims

1. A sealing system for a vacuum chamber in which an opening is defined, the system comprising:
a printed circuit board comprising:
a first part for exposing to an atmospheric environment, and
a second part adjacent to the first part for exposing to a vacuum environment, wherein the second part is configured to at least partially cover the opening in the vacuum chamber,
wherein the first part is configured to extend away from the opening for accommodating an interface.

2. The system of claim 1, further comprising a support structure configured to support the second part of the printed circuit board during exposure to the vacuum environment.

3. The system of claim 2, wherein the support structure is disposed on the second part of the printed circuit board.

4. The system of claim 2, wherein the support structure, in use, is disposed across the opening of the vacuum chamber.

5. The system of claim 4, wherein the support structure is configured to be attached to a rim of the opening of the vacuum chamber.

6. The system of any of the preceding claims, wherein the vacuum chamber comprises a wall defining the opening, and wherein the printed circuit board is configured to be attached to the wall such that the second part at least partially covers the opening.

7. The system of any of claims 1 to 5, wherein the vacuum chamber comprises a flange surrounding the opening, and wherein the printed circuit board is configured to be attached to the flange.

8. The system of claim 7 when dependent on claim 2, wherein the support structure, in use, is attached to the flange.

9. The system of any of the preceding claims, wherein the printed circuit board, in use, is soldered, welded, or glued to the vacuum chamber such that the second part at least partially covers the opening.

10. The system of any of the preceding claims, wherein the opening is non-circular.

11. The system of any of the preceding claims, wherein the opening has a greater length in a longitudinal direction of the opening than the length of the opening in a width direction orthogonal to the longitudinal direction.

12. The system of claims 11, wherein the opening is substantially rectangular.

13. The system of any of the preceding claims, wherein the second part is configured to entirely cover the opening.

14. The system of any of the preceding claims, wherein the interface comprises electronic input and/or output channels, cooling fluid input and/or output channels, and/or optical input and/or output channels.

15. The system of any of claims 2 to 14, wherein the support structure is in the form of a mesh, and/or wherein the support structure includes one or more beams, and/or wherein the support structure includes a plate configured to cover at least part of a surface of the second part.
